# EUROPEAN PATENT SPECIFICATION

(11) **EP 0 526 644 B1**
(45) Date of publication and mention of the grant of the patent: **26.07.1995**
(21) Application number: 92904981.5
(22) Date of filing: 12.02.1992
(51) Int. Cl.: H01L 21/31, H01L 21/00

(54) **SEMICONDUCTOR MANUFACTURING EQUIPMENT**
VORRICHTUNG ZUM HERSTELLEN VON HALBLEITERN
INSTALLATION POUR LA FABRICATION DE SEMICONDUCTEURS

(30) Priority: 15.02.1991 JP 22359/91
(43) Date of publication of application: 10.02.1993
(73) Proprietor: SEMICONDUCTOR PROCESS LABORATORY CO., LTD., Minato-ku, Tokyo 108 (JP); CANON SALES CO., INC., Minato-ku, Tokyo 108 (JP); ALCAN-TECH CO., INC., Tokyo 108 (JP)
(72) Inventor: MAEDA, Kazuo Semiconductor Process Lab. Co. Ltd., Minato-ku Tokyo 108 (JP); OHIRA, Kouichi Semiconductor Process Lab. Co. Ltd., Minato-ku Tokyo 108 (JP); HIROSE, Mitsuo, Minato-ku Tokyo 108 (JP)
(74) Representative: Marx, Lothar, Dr.
(86) International application number: PCT/JP92/00136
(87) International publication number: WO 92/15115

(56) References cited:
- JP-A-63 076 334
- US-A- 4 777 804

## Description

### TECHNICAL FIELD

The present invention relates to a semiconductor fabrication equipment for forming a film on a wafer by a CVD method.

### BACKGROUND ART

In a conventional CVD system, a film is formed on a wafer utilizing the chemical reaction by a reaction gas. Accordingly, unnecessary particles as sub-products are stuck on the gas releasing surface of a gas dispersing device, and further this particles are separated from the gas releasing surface and then stuck on the wafer, thereby causing contamination of the wafer. Therefore, in the CVD system, it is necessary to clean the gas releasing surface of the gas dispersing device on a specified cycle.

In a plasma CVD system, even if particles as sub-products are stuck on the gas releasing surface or the like of a gas dispersing device, the inside of a chamber can be depressurized and thereby the particles stuck on the gas releasing surface can be simply removed by introducing an etching gas in the chamber after the formation of a film. This technique, which is called as an in-situ cleaning, is put in practice.

Meanwhile, in an atmospheric pressure CVD system, as it is known from JP-A-63-76 334, when a reaction gas such as a mixed gas of SiH₄-O₂ or TEOS-O₃ is released from a gas releasing device, the reaction products are stuck on the gas releasing surface as powder-like particles. However, in this CVD system, since the inside of a chamber cannot be depressurized, it is impossible to perform the in-situ cleaning differently from the above plasma CVD system. Accordingly, the particles on the gas releasing surface must be physically removed by a cleaner or chemically removed by chemicals such as hydrofluoric acid (HC) after stopping this CVD system.

As a result, in the atmospheric pressure CVD system, the cleaning takes a lot of time or labor thereby reducing an uptime ratio thereof. Also, in this system, there occurs such a trouble that, when the deposited powder is remarkably increased, it is difficult to be removed.

Taking the above conventional problems into consideration, the present invention has been made, and an object is to provide a semiconductor fabrication equipment, wherein the dust generated in a chamber can be easily removed without reducing the uptime ratio of the equipment.

### DISCLOSURE OF THE INVENTION

In a first aspect of the present invention, there is provided a semiconductor fabrication equipment comprising: one or more gas dispersing devices, each being adapted to release a reaction gas for forming a film on a wafer from a gas releasing surface; one or more wafer holders having wafer mounting surfaces, each being opposed to the plane including the gas releasing surface; and one or more cleaners, each having a suction port and a brush connected to the suction port and being opposed to the plane including the gas releasing surface, wherein either the cleaner or the gas dispersing device is moved under the state that the cleaner is opposed to the plane including the gas dispersing surface and the brush is brought in contact with the gas releasing surface. This makes it possible that, at least either before or after the film formation, the gas releasing surface is brushed by the brush and simultaneously the separated dust from the gas releasing surface is sucked and removed from a suction port, and therefore, the dust remaining in a chamber can be reduced.

In a second aspect of the present invention, there is provided a semiconductor fabrication equipment according to the first aspect, including a rotational shaft, wherein each of the wafer holders is provided so as to be along the circumference of the rotating shaft and to be fixed on the rotating shaft; each of the gas dispersing devices is provided such that the plane including the gas releasing surface is opposed to the wafer mounting surface; and the wafer holder and the cleaner are turned around the rotating shaft under the state of being opposed to the plane including the gas releasing surface. With this construction, since the wafer holder and the cleaner are moved along a so-called endless track, it is possible to provide a continuous automatic film formation system such as a CVD system.

In a third aspect of the present invention, there is provided a semiconductor fabrication equipment according to the first invention, including a rotating shaft, wherein each of the gas dispersing devices is provided so as to be along the circumference of the rotating shaft and to be fixed on the rotating shaft; each of the wafer holders is provided such that the wafer mounting surface is opposed to the plane including the gas releasing surface; and each of the gas dispersing devices is turned around the rotating shaft under the state that the plane including the gas releasing surface is opposed to the wafer holder and the cleaner. With this construction, since the gas dispersing device is moved along a so-called endless track, it is possible to provide a continuous automatic film formation system such as a CVD system.

In a fourth aspect of the present invention, the above cleaners are integrally provided on the side surfaces of at least one of the wafer holders.

In a fifth aspect of the present invention, the above cleaners are fixed on the rotating shaft separately from the wafer holder so as to be positioned between at least a set of adjacent wafer holders.

With this construction, either before or after the film formation, the cleaning is frequently carried out by transferring the gas dispersing device or the wafer holder, and consequently, it is possible to secure the higher cleanliness in the chamber. Also, since the dust generated in the chamber can be easily removed without opening the chamber, it is possible to eliminate the necessity of stopping the equipment as compared with the conventional one and hence to prevent the lowering the uptime ratio of the equipment.

### BRIEF DESCRIPTION OF THE DRAWINGS

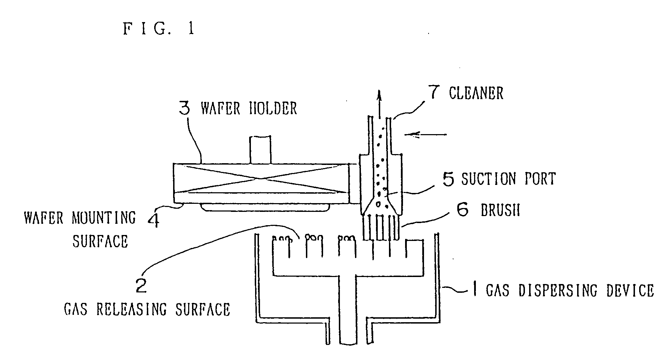

Fig. 1 is a structural view showing a principle of a semiconductor fabrication equipment according to the present invention;
Fig. 2 is a side structural view for explaining a CVD system of a first example according to the present invention;
Fig. 3 is a top elevational view for explaining the details of wafer holders and gas dispersing devices in the CVD system of the first example according to the present invention;
Fig. 4 is a side an elevational view for explaining the details of cleaners in the CVD system of the first example according to the present invention;
Fig. 5 is a cross-sectional view (first) for explaining a method for applying a CVD system of a second example according to the present invention; and
Fig. 6 is a cross-sectional view (second) for explaining a method for applying the CVD system of a second example according to the present invention.

### BEST MODE FOR CARRYING OUT THE INVENTION

The present invention will be described in detail with reference to the accompanying drawings.

### (1) Example 1

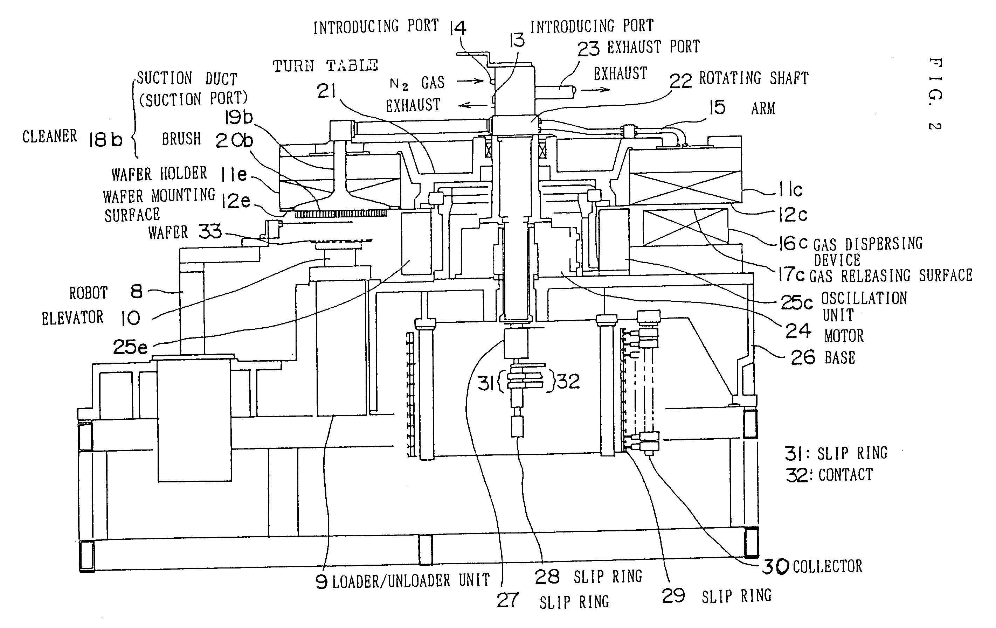

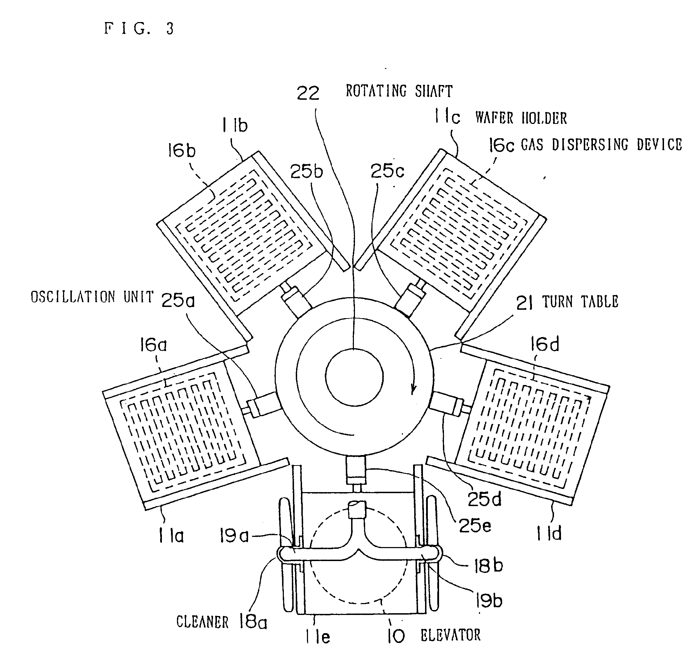

Figs. 2, 3 and 4 are structural views for explaining a CVD system in this example of the present invention, wherein Fig. 2 is a side view showing a whole construction of the CVD system; Fig. 3 is a top elevational view partially showing gas dispersing devices and wafer holders of Fig. 2; and Fig. 3 is a side elevational view showing the details of a cleaner integrally provided with the wafer holder.

In Figs. 2, 3 and 4: numeral 8 indicates a robot for transferring wafers to or from a loader/unloader unit 9 of a semiconductor fabrication equipment; 10 is an elevator provided on the loader/unloader unit 9 of the semiconductor fabrication equipment vertically movable for mounting or removing the transferred wafers onto or from wafer mounting surfaces 12a to 12e of the wafer holders 11a to 11e.

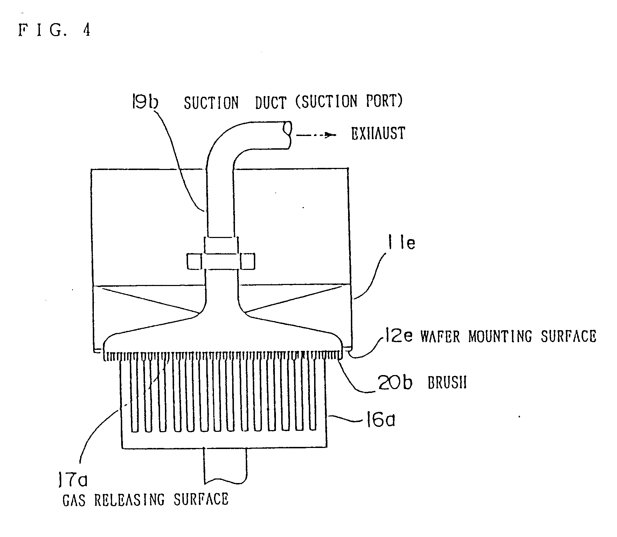

Numerals 11a to 11e indicate respective wafer holders for holding the wafers during forming films on the surfaces of the wafers, and more specifically, for fixing or removing the wafers onto or from the wafer mounting surfaces 12a to 12e by a chuck fluidly connected to an exhaust port 13 connected to an exhauster or a nitrogen gas introducing port 14 through a pipe-like arm 15. Also, as shown in Fig. 3, the wafer holders 11a to 11e are provided around a rotating shaft 22. They are fixed through the rotating shaft 22, the arm 15 and a turntable 21 to be turned around the rotating shaft 22 together with the rotation thereof. Further, 16a to 16d are gas dispersing devices for releasing a reaction gas to the wafers, which are respectively provided with gas releasing surfaces 17a to 17d oppositely to the wafer mounting surfaces 12a to 12e. Numerals 18a and 18b are cleaners, which are respectively formed on both sides of the wafer holder 11e integrally with the wafer holder 11e. As shown in Fig. 4, each of the cleaners 18a and 18b includes blushes 20a and 20b respectively provided on the leading edges of the suction ducts (suction ports) 19a and 19b so as to be brought in contact with the gas releasing surfaces 17a to 17d of the gas dispersing devices 16a to 16d. The cleaners 18a and 18b are moved under the state that the brushes 20a and 20b are opposed to the plane including the gas releasing surfaces 17a to 17d, thereby brushing the gas releasing surfaces 17a to 17d by the brushes 20a and 20b. At the same time, the dust separated from the gas releasing surfaces 17a to 17d are sucked and removed by a suction duct 19. Further, the suction duct 19 is fluidly connected to an exhaust port 23 connected to an exhauster (not shown).

Numeral 22 indicates a rotating shaft, which is integrated with the wafer holders 11a to 11e and is rotated such that the wafer mounting surfaces 12a to 12e are moved on one plane; 24 is a motor such as a direct drive motor for turning the wafer holders 11a to 11e; 25a to 25e are oscillation units for linearly reciprocating the wafer holders 11a to 11e in the specified directions with the held positions as base points, respectively; 26 is a box-like base for mounting the gas dispersing devices 16a to 16d on its circumferential portion and for accommodating one end of the rotating shaft 22 at its central portion in such a manner as to make possible the rotation of the rotating shaft having the wafer holders 11a to 11e at the other end; 27 is a slip ring for transmitting a signal to control a solenoid valve provided at one end of the rotating shaft 22, wherein a rotary connector is used as an electric contact portion for preventing the rotation of the rotating shaft 22; 28 is a slip ring for outputting a signal from a thermocouple for measuring the temperature of a heater, wherein a contact 32 is brought in contact therewith for preventing the rotation of the rotating shaft 22; 29 is a slip ring connected to the contact 32; 30 is a collector having one end being contact with the slip ring 29 and the other end connected to an electric power supply (not shown) for supplying a d.c or a.c power to heaters buried in the wafer holders 11a to 11e.

In the above-mentioned CVD system of the present invention, the cleaners 18a and 18b having the brushes 20a and 20b and the suction ducts 19a and 19b are moved under the state of being opposed to the plane including the gas releasing surfaces 17a to 17d of the gas dispersing devices 16a to 16d. At this time, the brushes 20a and 20b are set to be brought in contact with the gas releasing surfaces 17a to 17d. Consequently, in transferring the wafer holder 11e before or after the film formation, the brushes 20a and 20b physically rub the gas releasing surfaces 17a to 17d, and simultaneously the dust separated from the gas releasing surfaces 17a to 17d by the brushing is sucked and removed by the suction ports 19a and 19b. Therefore, it is possible to reduce the dust remaining in the chamber.

Further, since the cleaners 18a and 18b are integrally formed at both ends of the wafer holder 11e respectively, the cleaning can be carried out in transferring the wafer holder 11e before or after the film formation. Accordingly, the dust generated in the chamber can be easily removed without opening the chamber. This makes it possible to eliminate the necessity of stopping the CVD system and hence to prevent the lowering of the uptime ratio thereof.

Further, since the cleaning can be frequently carried out in transferring the wafer holder 11e, it is possible to secure the higher cleanliness in the chamber.

Also, since the wafer holders 11a to 11e and the cleaners 18a and 18b are turned while being fixed to the rotating shaft, they move along a so-called endless track, and therefore, it is possible to provide a continuous automatic film formation equipment such as a CVD system.

In addition, in this example, the cleaners 18a and 18b are respectively provided at both ends of the wafer holder 11e; however, only one cleaner may be provided on one end thereof. Also, the cleaners 18a and 18b are provided on only one wafer holder 11e; however, they may be provided on all of the wafer holders 11a to 11e.

Further, this invention is applied to the case that the film is formed on the wafer set in the face-down state; however, it is applicable to the case that the film is formed on the wafer set in the face-up state.

Also, the cleaners 18a and 18b are integrally formed on the wafer holder 11e; however, they may be separated from the wafer holder 11e, and independently fixed on the rotating shaft 22 so as to be positioned, for example, between the wafer holders 11e and 11a, or between the wafer holders 11e and 11d.

Further, although the wafer holders 11a and 11e and the cleaners 18a and 18b are set to be moved; however, if necessary, they may be fixed and the gas dispersing devices 16a and 16d may be moved.

### (2) Example 2

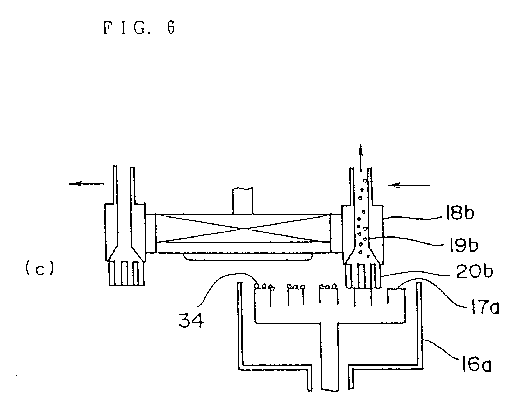

Hereinafter, there will be described a method for forming a single insulating film on a wafer using a CVD system as shown in Figs. 2, 3 and 4 with reference to Figs. 2 to 6. In this example, a specified thickness of a CVD SiO2 film is formed in one turn of a wafer holder around a rotating shaft.

As shown in Fig. 2, a first wafer is transferred from a cassette station to a loader/unloader section 9 by a robot 8, and is then mounted on an elevator 10.

The elevator 10 is lifted, and the first wafer 33 is mounted on a wafer holder 11e together with the evacuation through an exhaust port 13. Then, a slip ring 27 corresponding to the chuck of the wafer holder 11e receives a signal to open a solenoid valve, thus fixing the first wafer on a wafer mounting surface 12e. At this time, heaters of all wafer holders 11a to 11e are applied with an electric power through a slip ring 31, contact 32, slip ring 29 and collector 30 corresponding to the wafer holders 11a to 11e, so that wafer mounting surfaces 12a to 12e of the wafer holders 11a to 11e are kept at approximately 350 °C.

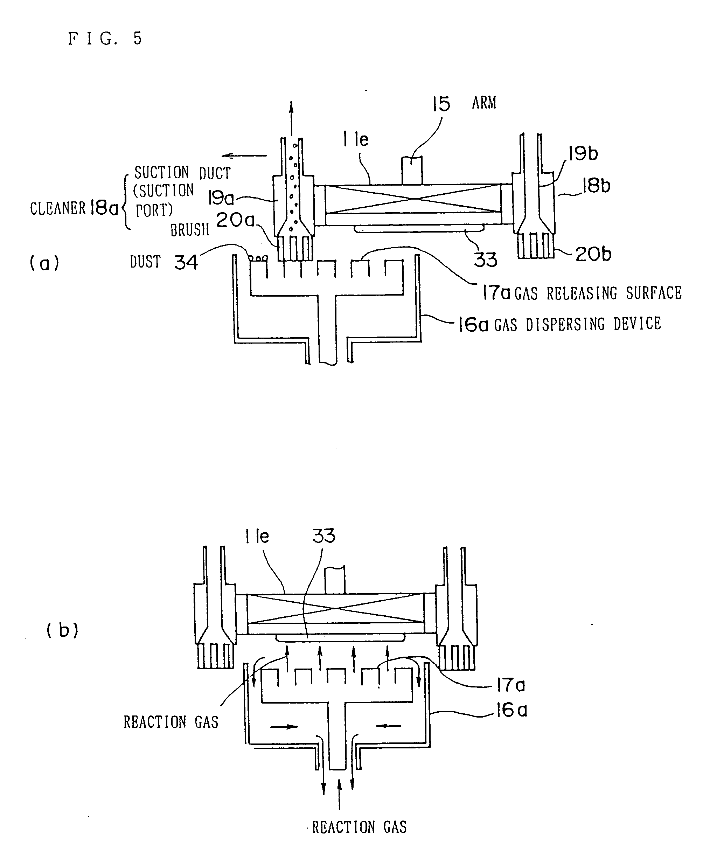

After the first wafer 33 is heated at approximately 350°C, the rotating shaft 22 is rotated so as to move the wafer holder 11e at the position directly over the gas dispersing device 16a. At this time, as shown in Fig. 5a, the brush 20a of the cleaner 18a brushes the gas releasing surface 17a of the gas dispersing device 16a thereby separating the dust 34 stuck on the gas releasing surface 17a due to the previous reaction, sucking the separated dust 34 by the sucking duct 19a connected to the brush 20a, and removing the dust 34 to the exterior of the system by way of the exhaust port as shown in Fig. 2.

As shown in Fig. 5b, the wafer holder 11e is stopped at the position directly over the gas dispersing device 16a, and simultaneously the mixed gas of TEOS-O₃ as the reaction gas is released from the gas releasing surface 17a of the gas dispersing device 16a. At this time, while the deposition rate of the SiO₂ film is adjusted at a value of approximately 2000 Å/min, the above state is held for approximately 1 min., so that the SiO₂ film is formed on the first wafer 33 to a thickness of approximately 2000 Å which is approximately 1/5 times as much as the target thickness. The SiO₂ film thus obtained is preferable in quality without any defect, because the dust 34 generated on the gas releasing surface 17a is removed, and thereby the surface of the wafer 33 is kept in the clean state during the film formation. Further, during the film formation, the wafer holder 11e is linearly reciprocated in the radial direction with the held position taken as a base point by the oscillating unit 25e, so that the supply of the reaction gas on the wafer 33 is equalized which makes uniform the thickness and the quality of the SiO₂ film. At the same time, the second wafer is mounted on the wafer holder 11d positioned on the loader/unloader 9 in the same manner as the above and heated at approximately 350°C.

Then, in order to move the wafer holders 11e and 11d at the positions directly over the gas dispersing devices 11a and 11b, the rotating shaft 22 is rotated. At this time, as shown in Fig. 5c, the brush 20b of the cleaner 18b brushes the gas releasing device 17a of the gas releasing device 16a thereby separating the dust 34 stuck by the previous reaction, sucking the separated dust 34 by the sucking duct 19b connected to the brush 20b, and removing the dust 34 to the exterior of the system by way of the exhaust port 23 as shown in Fig. 2. Accordingly, it is possible to secure the preferable quality of the SiO₂ film formed on the next wafer.

The rotating shaft 22 is further rotated for stopping the wafer holders 11e and 11d at the positions directly over the gas releasing devices 11a and 11b. At this time, since the second wafer is already heated at approximately 350°C, the film formation can be immediately started. Accordingly, the mixed gas of TEOS-O₃ as a reaction gas is released from the gas dispersing devices 11a and 11b. By keeping the above state for approximately 1 min, the SiO₂ film is formed on the first wafer 33 to a thickness of approximately 4000Å which is approximately 2/5 times as much as the target thickness, and the SiO₂ film is formed on the second wafer 33 to a thickness of approximately 2000Å which is approximately 1/5 times as much as the target thickness.

Thus, the wafers are sequentially set on the wafer holders 11c, 11b and 11a, and the SiO₂ films are respectively formed on the wafers. When being returned to the loader/unloader section 9 after one turn around the rotating shaft 22, the first wafer 33 is formed with the SiO₂ film having the target thickness.

The elevator 10 is then lifted, and the slip ring 27 corresponding to the chuck for the wafer mounting surface 12e of the wafer holder 11e receives a signal to close the solenoid valve of the exhaust port 13 and to open the solenoid valve of the introducing port 14 for supplying the nitrogen gas to the chuck. Thus the first wafer 33 is removed from the wafer mounting surface and placed on the elevator 10. Then, the first wafer 33 is transferred to the cassette station by the robot 8. Thus, the wafers formed with the SiO₂ having the specified thickness are sequentially accommodated in the cassette station.

As mentioned above, in the method for forming the SiO₂ film according to this example, since the brushes 20a and 20b physically rub the gas releasing surface 17a before or after the film formation, and simultaneously the dust separated from the gas releasing surface 17a by the above brushing is sucked and removed by the suction ducts 19a and 19b, it is possible to reduce the remaining dust in the chamber.

Also, since the cleaning is carried out at the time of moving the wafer holder 11e before or after the film formation, it is possible to easily remove the dust generated in the chamber without opening the chamber. This eliminates the necessity of stopping the system, which makes it possible to prevent the lowering of the uptime ratio of the system as compared with the conventional method. Further, since the cleaning can be frequently carried out at the time of moving the wafer holder 11e, it is possible to keep the higher cleanliness in the chamber.

Further, the wafer holders 11e and cleaners 18a and 18b are fixed on the rotating shaft 22 and rotated together with the rotating shaft 22, so that it is possible to continuously form the SiO₂ film or the like and hence to improve the throughput.

In addition, in this example, the cleaning is carried out only twice before and after the film formation in one turn of the rotating shaft 22, which is seemed to be enough in practical use; however, if necessary, by attaching the cleaners on the side portions of the other wafer holders and performing the multi-number of cleaning during one turn of the rotating shaft, it is possible to keep the inside of the chamber at the further clean state.

### INDUSTRIAL APPLICABILITY

As mentioned above, the semiconductor fabrication equipment according to the present invention is useful for the continuous automatic film formation equipment such as a CVD system, and particularly applicable for formation of a further preferable film without reducing the uptime ratio of the system.

### Explanation of Numerals

1 and 16a to 16d...gas dispersing device, 2 and 17a to 17d...gas releasing surface, 3 and 11a to 11e...wafer holder, 4 and 12a to 12e...wafer mounting surface, 5...suction port, 6 and 19a and 19b...brush, 7 and 18a and 18b...cleaner, 8...robot, 9...loader/unloader section, 10...elevator, 13 and 23...exhaust port, 14...introducing port, 15...arm, 20a and 20b...suction duct (suction port), 21...turn table, 22...rotating shaft, 24...motor, 25a to 25e...oscillation unit, 26...base, 27, 28, 29 and 31...slip ring, 30...collector, 32...contact, 33...wafer, 34...dust

### Drawings

Fig. 1
   1...gas dispersing device
   2...gas releasing device
   3...wafer holder
   4...wafer mounting surface
   5...suction port
   6...brush
   7...cleaner
Fig. 2
   8...robot
   9...loader/unloader section
   10...elevator
   11e...wafer holder
   12e...wafer mounting surface
   13...exhaust port
   14...introducing port
   15...arm
   16c...gas dispersing device
   17c...gas releasing surface
   18b...cleaner
   19b...suction duct (suction port)
   20b...brush
   21...turntable
   22...rotating shaft
   23...exhaust port
   24...motor
   25c...oscillation unit
   26...base
   27...slip ring
   28...slip ring
   29...slip ring
   30...collector
   31...slip ring
   32...contact
   33...wafer
      a...N₂ gas
      b...exhaust
      c...exhaust
Fig. 3
   10...elevator
   11c...wafer holder
   16c...gas dispersing device
   18a...cleaner
   21...turntable
   22...rotating shaft
   25a...oscillation unit
Fig. 4
   12e...wafer mounting surface
   17a...gas releasing surface
   19b...suction duct (suction port)
   20b...brush
Fig. 5
   (a)
      15...arm
      16a...gas dispersing device
      17a...gas releasing surface
      18a...cleaner
      19a...suction duct (suction port)
      20a...brush
   (b)
      a...reaction gas

## Claims

1. A semiconductor fabrication equipment comprising:
one or more gas dispersing devices, (1, 16c) each being adapted to release a reaction gas for forming a film on a wafer (33) from a gas releasing surface (2, 17c);
one or more wafer holders (3, 11e) having wafer mounting surfaces (4, 12e), each being opposed to the plane including said gas releasing surface (2, 17c) characterized by
one or more cleaners (7, 18b), each having a suction port (5, 19b) and a brush (6, 20b) connected to said suction port (5, 19b) and being opposed to the plane including said gas releasing surface (2, 17c),
wherein either said cleaner (7, 18b) or said gas dispersing device (1, 16c) is movable whereby said cleaner (7, 18b) is maintained opposed to the plane including said gas dispersing surface, and said brush (6, 20b) is brought in contact with said gas releasing surface (2, 17c).

2. A semiconductor fabrication equipment according to claim 1, including a rotational shaft (22), wherein
each of said wafer holders (3, 11e) is provided so as to be along the circumference of said rotating shaft (22) and to be fixed on said rotating shaft (22);
each of said gas dispersing devices (1, 16c) is provided such that the plane including said gas releasing surface (2, 17c) is opposed to said wafer mounting surface (4, 12e); and
each of said wafer holders (3, 11e) and each of said cleaners (7, 18b) are rotatable around said rotating shaft (22) whereby said wafer holder (3, 11e) and said cleaner (7, 18b) are maintained opposed to the plane including said gas releasing surface (2, 17c).

3. A semiconductor fabrication equipment according to claim 1, including a rotating shaft (22), wherein
each of said gas dispersing devices (1, 16c) is provided so as to be along the circumference of said rotating shaft (22) and to be fixed on said rotating shaft;
each of said wafer holders (3, 11e) is provided such that said wafer mounting surface (4, 12e) is opposed to the plane including said gas releasing surface (2, 17c); and
each of said gas dispersing devices (1, 16c) is turnable around said rotating shaft (22) whereby said wafer holder (3, 11e) and said cleaner (7, 18b) are maintained opposed to the plane including said gas releasing surface (2, 17c).

4. A semiconductor fabrication equipment according to claim 1, 2 or 3, wherein said cleaners (7, 18b) are integrally provided on the side portions of at least one of the wafer holders (3, 11e).

5. A semiconductor fabrication equipment according to claim 2 or 3, said cleaners (7, 18b) are fixed on said rotating shaft (22) separately from said wafer holder (3, 11e) so as to be positioned between at least a set of said wafer holders (3, 11e) adjacent to each other.

## Patentansprüche

1. Vorrichtung zum Herstellen von Halbleitern, umfassend:
eine oder mehrere Gasdispersionseinrichtungen (1, 16c), die geeignet ist, von einer Gasfreisetzungsfläche (2, 17c) ein Reaktionsgas zum Bilden eines Films auf einem Wafer (33) freizusetzen;
einen oder mehrere Waferhalter (3, 11e), die Waferhalteflächen (4, 12e) aufweisen, die jeweils der Ebene, welche die Gasfreisetzungsfläche (2, 17c) enthält, gegenüberliegen,
gekennzeichnet durch
einen oder mehrere Reiniger (7, 18b), die jeweils eine Saugöffnung (5, 19b) und eine mit dieser Saugöffnung (5, 19b) verbundene Bürste (6, 20b) aufweisen und die der Ebene, welche die Gasfreisetzungsfläche (2, 17c) enthält, gegenüberliegen,
wobei entweder der Reiniger (7, 18b) oder die Gasdispersionseinrichtung (1, 16c) bewegbar ist, wodurch der Reiniger (7, 18b) der Ebene, welche die Gasfreisetzungsfläche (2, 17c) enthält, gegenüberliegend gehalten und die Bürste (6, 20b) in Kontakt mit der Gasfreisetzungsfläche (2, 17c) gebracht wird.

2. Vorrichtung zum Herstellen von Halbleitern nach Anspruch 1, umfassend eine sich drehende Welle (22), bei der
jeder der Waferhalter (3, 11e) am Umfang der sich drehenden Welle (22) angeordnet und auf der sich drehenden Welle (22) befestigt ist;
jede der Gasdispersionseinrichtungen (1, 16c) so angeordnet ist, daß die Ebene, welche die Gasfreisetzungsfläche (2, 17c) enthält, der Waferhaltefläche (4, 12e) gegenüberliegt; und bei der
jeder der Waferhalter (3, 11e) und jeder der Reiniger (7, 18b) drehbar um die sich drehende Welle (22) ist, wodurch der Waferhalter (3, 11e) und der Reiniger (7, 18b) der Ebene, welche die Gasfreisetzungsfläche (2, 17c) enthält, gegenüberliegend gehalten werden.

3. Vorrichtung zum Herstellen von Halbleitern nach Anspruch 1, bei der jede der Gasdispersionseinrichtungen (1, 16c) am Umfang der sich drehenden Welle (22) angeordnet und auf der sich drehenden Welle (22) befestigt ist;
jeder der Waferhalter (3, 11e) so angeordnet ist, daß die Waferhaltefläche (4, 12e) der Ebene, welche die Gasfreisetzungsfläche (2, 17c) enthält, gegenüberliegt; und bei der
jede der Gasdispersionseinrichtungen (1, 16c) drehbar um die sich drehende Welle (22) ist, wodurch der Waferhalter (3, 11e) und der Reiniger (7, 18b) der Ebene, welche die Gasfreisetzungsfläche (2, 17c) enthält, gegenüberliegend gehalten werden.

4. Vorrichtung zum Herstellen von Halbleitern nach Anspruch 1, 2 oder 3, bei der die Reiniger (7, 18b) auf den Seitenabschnitten von zumindest einem der Waferhalter (3, 11e) integriert ausgebildet sind.

5. Vorrichtung zum Herstellen von Halbleitern nach Anspruch 2 oder 3, bei dem die Reiniger (7, 18b) auf der sich drehenden Welle (22) von dem Waferhalter (3, 11e) getrennt befestigt sind, um zwischen zumindest einem Satz von nebeneinanderliegenden Waferhaltern (3, 11e) angeordnet werden zu können.

## Revendications

1. Equipement de fabrication de semiconducteurs, comprenant :
un ou plusieurs dispositifs (1, 16c) de dispersion de gaz, chacun étant conçu pour émettre un gaz de réaction afin de former une couche mince sur une plaquette (33) à partir d'une surface (2, 17c) d'émission de gaz;
un ou plusieurs porte-plaquettes (3, 11e) ayant des surfaces (4, 12e) de support de plaquettes, chacun faisant face au plan contenant ladite surface (2, 17c) d'émission de gaz, caractérisé par
un ou plusieurs aspirateurs (7, 18b), chacun ayant un orifice d'aspiration (5, 19b) et une brosse (6, 20b) reliée audit orifice d'aspiration (5, 19b) et faisant face au plan contenant ladite surface (2, 17c) d'émission de gaz,
dans lequel ledit aspirateur (7, 18b) ou ledit dispositif (1, 16c) de dispersion de gaz est mobile, grâce à quoi ledit aspirateur (7, 18b) est maintenu face au plan contenant ladite surface de dispersion de gaz et ladite brosse (6, 20b) est placée au contact de ladite surface (2, 17c) d'émission de gaz.

2. Equipement de fabrication de semiconducteurs selon la revendication 1, comportant un arbre rotatif (22), dans lequel
chacun desdits porte-plaquettes (3, 11e) est placé de façon à se trouver sur le pourtour dudit arbre rotatif (22) et à être fixé sur ledit arbre rotatif (22);
chacun desdits dispositifs (1, 16c) de dispersion de gaz est disposé d'une façon telle que le plan contenant ladite surface (2, 17c) d'émission de gaz fait face à ladite surface (4, 12e) de support de plaquette; et
chacun desdits porte-plaquettes (3, 11e) et chacun desdits aspirateurs (7, 18b) peuvent tourner autour dudit arbre rotatif (22), grâce à quoi ledit porte-plaquette (3, 11e) et ledit aspirateur (7, 18b) sont maintenus face au plan contenant ladite surface (2, 17c) d'émission de gaz.

3. Equipement de fabrication de semiconducteurs selon la revendication 1, comportant un arbre rotatif (22), dans lequel
chacun desdits dispositifs (1, 16c) de dispersion de gaz est placé de façon à se trouver sur le pourtour dudit arbre rotatif (22) et à être fixé sur ledit arbre rotatif;
chacun desdits porte-plaquettes (3, 11e) est disposé d'une façon telle que ladite surface (4, 12e) de support de plaquette fait face au plan contenant ladite surface (2, 17c) d'émission de gaz; et
chacun desdits dispositifs (1, 16c) de dispersion de gaz peut tourner autour dudit arbre rotatif (22), grâce à quoi ledit porte-plaquette (3, 11e) et ledit aspirateur (7, 18b) sont maintenus face au plan contenant ladite surface (2, 17c) d'émission de gaz.

4. Equipement de fabrication de semiconducteurs selon la revendication 1, 2 ou 3, dans lequel lesdits aspirateurs (7, 18b) font corps avec les parties latérales d'au moins un des porte-plaquettes (3, 11e).

5. Equipement de fabrication de semiconducteurs selon la revendication 2 ou 3, dans lequel lesdits aspirateurs (7, 18b) sont fixés séparément dudit porte-plaquette (3, 11e) sur ledit arbre rotatif (22) de façon à être placés entre deux au moins desdits porte-plaquettes (3, 11e) voisins immédiats l'un de l'autre.
